(19) Europäisches Patentamt
European Patent Office
Office européen des brevets

(11) **EP 3 846 068 A1**

(12) **DEMANDE DE BREVET EUROPEEN**

(43) Date de publication:
**07.07.2021 Bulletin 2021/27**

(51) Int Cl.:
*G06F 30/20* (2020.01)  *H04N 7/18* (2006.01)

(21) Numéro de dépôt: **20217983.4**

(22) Date de dépôt: **31.12.2020**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
**KH MA MD TN**

(30) Priorité: **31.12.2019 FR 1915797**

(71) Demandeur: **Data Smart Process**
**10430 Rosières près Troyes (FR)**

(72) Inventeur: **REBAI, Maher**
**51100 Reims (FR)**

(74) Mandataire: **Debay, Damien**
**Debay IP**
**126 Résidence Elysée 2**
**18, avenue de la Jonchère**
**78170 La Celle-Saint-Cloud (FR)**

(54) **PROCÉDÉ ET SYSTÈME DE DÉPLOIEMENT DE CAMÉRAS DE SURVEILLANCE**

(57)  [La présente invention concerne un procédé et un système de déploiement de caméras de surveillance d'une zone (Z), pour l'optimisation l'efficacité de la surveillance, ledit déploiement étant réalisé sur la base d'une cartographie (CG) tridimensionnelle de ladite zone (Z) et une optimisation (53) de paramètres, par au moins un algorithme (A) d'optimisation mono-objectif ou multi-objectifs basé sur la cartographie de la zone (Z) et comprenant au moins la définition et la détermination de valeurs optimales de paramètres multiples (objectifs et/ou contraintes) comportant au moins le coût des caméras ou le nombre de caméra pour couvrir une région de la zone à surveiller ou la résolution des caméras, lesdites caméras étant déployées sur la zone selon les valeurs optimales obtenues.

[Fig1]

Figure 1

EP 3 846 068 A1

**Description**

**DOMAINE TECHNIQUE DE L'INVENTION**

[La présente invention se rapporte au domaine de la surveillance par caméra, de lieux divers, dits zone, tels que des complexes industriels ou des habitations personnelles. L'invention se rapporte plus particulièrement au déploiement de caméras pour la surveillance vidéo de telles zones. Par le terme « déploiement de caméras », on entend, dans la présente demande, le fait d'installer des caméras de divers types, avec des positions et des caractéristiques optimisées en fonction des besoins de surveillance de ladite zone. L'invention concerne plus précisément l'optimisation du déploiement des caméras par des algorithmes tenant compte des contraintes et objectifs imposés par la configuration physique de ladite zone.

**ARRIERE-PLAN TECHNOLOGIQUE DE L'INVENTION**

Il est connu de l'art antérieur des systèmes de surveillance de zones par des caméras que, des caméras de divers types (et caractéristiques techniques) soient déployées dans la zone. Certaines caméras sont fixées sur des supports avec un angle fixe, tandis que d'autres ont des orientations mobiles selon plusieurs angles (dans le plan horizontal et/ou vertical), mais des paramètres tels que la résolution et/ou le recouvrement des champs d'acquisition de plusieurs caméras restent difficiles à optimiser. Par exemple, de façon non limitative, il peut être souhaité d'avoir une résolution permettant la reconnaissance d'une plaque d'immatriculation d'un véhicule ou une reconnaissance faciale, mais il peut également être souhaité d'avoir un recouvrement de champs d'acquisition (et optionnellement d'une résolution) permettant une reconstruction tridimensionnelle de l'entité (individu ou objet) à surveiller sur une partie de ladite zone surveillée.

Plusieurs méthodes ont été proposées dans la littérature pour traiter le problème de déploiement d'un réseau de caméras. Ces méthodes sont principalement dédiées à l'objectif de couverture. Il s'agit d'un problème d'optimisation NP difficile où l'objectif est de trouver les positions et les orientations 3D d'un nombre donné de caméras afin de maximiser la couverture de la zone surveillée. Une zone est considérée couverte si elle est incluse dans le champs de vue d'au moins une caméra. L'aspect 3D rend le problème difficile et différent de celui des réseaux de capteurs. Parmi ces méthodes, on peut citer le travail de Wang et al (Wang, Y., Cao, G. (2011) 'On-Full View Coverage in Camera Sensor Networks', INFOCOM, 2011 Proceedings IEEE , pp.1781-1789) qui propose une méthode géométrique pour optimiser la couverture. D'autre part, le travail de Horster et al. (Horster, E. and Lienhart, R. (2006) 'Approximating Optimal Visual Sensor Placement', IEEE International Conférence on Multimedia and Expo, July 2006 , pp. 1257-1260) propose de simplifier le problème et de le résoudre dans le cas d'un déploiement 2D en discrétisant la zone surveillée. De plus, on peut citer le travail de Howard et al. (Howard, A., Mataric, M.J., Sukhatme, G.S. (2002) 'An incremental self deployment algorithm for mobile sensor networks', Autonomous Robots , vol. 13, no. 2, pp. 113-126) qui modélise le problème de déploiement comme un Art Gallery Problem, ainsi que d'autres travaux comme ceux de Zang et al. (Zhang, H., Xia, L., Tian, F., Wang, P., Cui, J., Tang, C., Deng, N., Ma,N. (2013) 'An optimized placement algorithm for collaborative information processing at a wireless camera network', IEEE International Conférence on Multimedia and Expo (ICME13), pp.1-6) ou de Yabuta et Kitazawa (Yabuta, K. and Kitazawa, H. (2008) 'Optimum Camera Placement Considering Camera Spécification for Security Monitoring', ISCAS'08. IEEE International Symposium on Circuits and Systems , pp.2114-2117) qui visent tous deux un objectif qui reste principalement limité à la couverture. Enfin, on peut citer également le travail de Rebai et al. (Rebai, M., Le Berre, M., Hnaien, F. and Snoussi, H., Exact Biobjective Optimization Methods for Camera Coverage Problem in Three-Dimensional Areas, IEEE Sensors Journal, Volume: 16, Issue: 9, May1, 2016) qui propose un critère bi-objectifs : minimiser le coût de l'installation (en supposant disposer de plusieurs types de caméras avec différents coûts) et maximiser la couverture de l'espace surveillé. Une contrainte d'auto-protection a été aussi proposée dans Rebai et al. (Rebai, M., Le Berre, M., Hnaien, F. and Snoussi, H., Exact Biobjective Optimization Methods for Camera Coverage Problem in Three-Dimensional Areas, IEEE Sensors Journal, Volume: 16, Issue: 9, May1, 2016), où il s'agit de contraindre le déploiement de telle façon que chaque caméra soit dans le champ de vue d'une autre caméra.

Néanmoins, tous ces documents de l'art antérieur ne proposent pas de déploiement de caméras qui soit optimisé de manière efficace en fonction de plusieurs paramètres qui dépendent de la zone à surveiller et varient donc en fonction des diverses zones dans lesquelles des caméras doivent être déployées.

**DESCRIPTION GENERALE DE L'INVENTION**

La présente invention a donc pour but de pallier certains inconvénients de l'art antérieur en proposant un procédé et un système de déploiement de caméras permettant d'optimiser la surveillance d'une zone déterminée. A cet effet, l'invention vise à optimiser divers paramètres tels que le recouvrement entre les champs d'acquisition d'au moins deux caméras ou la résolution souhaitée pour les caméras de positions diverses dans la zone, mais également d'optimiser le coût global, ces divers paramètres imposant des contraintes et/ou des objectifs divers.

Ce but est atteint par un procédé de déploiement de caméras (1) de surveillance d'une zone (Z), pour l'optimisation l'efficacité de la surveillance, ledit déploiement étant réalisé sur la base d'une cartographie (CG) tridimensionnelle de ladite zone (Z), ladite cartographie (CG) incluant:

- une discrétisation (50) de ladite zone (Z) sous la forme d'un ensemble de points discrets ($P_{m,n,q}$) répartis dans un espace tridimensionnel représentatif de ladite zone (Z) à surveiller ;

- une définition (51) d'une position ($P_{i,j,k}$) pour chacune des caméras (1) à déployer dans ladite zone (Z), parmi ledit ensemble de points discrets ($P_{m,n,q}$);

- une définition (52) d'un champ d'acquisition (CA) pour chacune des caméras (1) à déployer dans ladite zone (Z); ledit procédé étant caractérisé en ce qu'il comporte une optimisation (53) de paramètres, par au moins un algorithme (A) d'optimisation mono-objectif ou multi-objectifs :

    déterminant des valeurs optimales de paramètres multiples, ces paramètres comprenant une première catégorie de paramètres, dits objectifs (Po), dont les valeurs sont à optimiser par ledit algorithme d'optimisation et une seconde catégorie de paramètres, dits contraintes (Pc), dont les valeurs sont déterminées par un utilisateur lors de la mise en œuvre de l'algorithme d'optimisation ;

    utilisant, soit en tant que paramètre de contrainte (Pc), soit en tant que paramètre d'objectif (Po), au moins les paramètres suivants:

        au moins un paramètre ($R_{m,n,q}$), dit de résolution (R), représentatif de la résolution d'images souhaitée en certains points ($P_{m,n,q}$) de la zone (Z) à surveiller;
        au moins un paramètre ($D_{m,n,q}$), dit de coût d'installation de la caméra à la position ($P_{m,n,q}$), représentatif du nombre et/ou d'informations relatives à chacune des caméras (1) à déployer dans ladite zone, notamment en termes de caractéristiques techniques et/ou d'installation dans ladite zone (Z).

Selon une autre particularité, le procédé comprend la définition d'un champ d'acquisition (CA) pour chacune des caméras (1) à déployer dans ladite zone (Z), ladite définition du dit champ d'acquisition (CA) étant fonction de la position ($P_{i,j,k}$) de chacune des caméras et d'une discrétisation des orientations des caméras, selon un angle de balayage (a) vertical, dit tilt, et un angle de balayage horizontal (β) vertical, dit pan.

Selon une autre particularité, le procédé comporte une définition d'un type (c) de caméra pour chacune des caméras (1) à déployer dans ladite zone (Z), ce type étant représentatif des caractéristiques techniques de la caméra en question.

Selon une autre particularité, ledit algorithme utilise une sous-fonction (F) relative à la résolution (R) imposant qu'une position ($P_{m,n,q}$) dans ladite zone (Z) doive être couverte avec une résolution d'image ($R_{m,n,q}$).

Selon une autre particularité ladite sous-fonction (F) s'exprime par l'équation suivante :

$$F_{mnq} = \left\{ \begin{pmatrix} i \\ j \\ k \\ \alpha \\ \beta \\ c \end{pmatrix}, P_{mnq} \text{ soit couvert au niveau } r = R_{mnq} \right.$$

dans laquelle α représente le tilt, β représente le pan, c représente le type de caméra et r représente la résolution de la caméra souhaitée au point ($P_{m,n,q}$) couvert dans la zone (Z).

Selon une autre particularité, ledit algorithme utilise un poids ($W_{m,n,q}$) permettant à un utilisateur dudit algorithme de définir une importance de la surveillance pour chacune des positions ($P_{m,n,q}$) au sein de ladite zone (Z).

Selon une autre particularité, lorsque ledit paramètre ($R_{m,n,q}$) de résolution, lorsqu'il est utilisé en tant que paramètre de contraintes (Pc), ledit algorithme utilise une fonction Y pour l'ensemble caméras qui s'exprime selon l'équation suivante :

$$\sum_{ijk\alpha\beta c \in F_{mnq}} Y_{ijk}^{c\alpha_t\beta_s} \geq 1, \forall\, m \in \{1,\dots,M\}, \forall\, n \in \{1,\dots,N,\}, \forall\, q \in \{1,\dots,Q\}$$

Selon une autre particularité, lorsque le coût est une contrainte, le procédé utilise une équation de type:

$$\sum_{c=1}^{C}\sum_{t=0}^{T}\sum_{s=0}^{S}\sum_{m=1}^{M}\sum_{n=1}^{N}\sum_{q=1}^{Q}(C_c + D_{mnq}) \cdot Y_{mnq}^{c\alpha_t\beta_s} \leq C_G$$

Selon une autre particularité, lorsque le coût est un objectif, le procédé utilise pour ledit coût une équation de type:

$$Min\left\{\sum_{c=1}^{C}\sum_{t=0}^{T}\sum_{s=0}^{S}\sum_{m=1}^{M}\sum_{n=1}^{N}\sum_{q=1}^{Q}(C_c + D_{mnq}) \cdot Y_{mnq}^{c\alpha_t\beta_s}\right\}$$

Selon une autre particularité, lorsque la résolution (R) est un objectif, le procédé utilise pour ladite résolution une équation de type:

$$Max\left\{\sum_{m=1}^{M}\sum_{n=1}^{N}\sum_{q=1}^{Q} W_{mnq} \cdot Z_{mnq}\right\}$$

la variable $Z_{mnq}$ étant définie par

$$Z_{mnq} = \begin{cases} 1, si\ le\ point\ P_{mnq} = (m,n,q)\ est\ \ couvert\ avec\ une\ résolution\ R_{mnq} \\ 0\ sinon \end{cases}$$

Selon une autre particularité, l'algorithme, lorsqu'il est un algorithme d'optimisation multi-objectif, utilise au moins un autre paramètre d'objectif (Po) à optimiser en même temps que le coût et/ou la résolution (R), l'un de ces derniers restant de préférence un paramètre (Pc) de contrainte.

Selon une autre particularité, l'autre paramètre d'objectif (Po) à optimiser en même temps que le coût et/ou la résolution (R) est un paramètre dit de K-couverture représentatif du recouvrement spatial (KC) entre les champs d'acquisition (CA) des caméras (1) pour chacun desdits points ($P_{m,n,q}$) de ladite zone.

Selon une autre particularité, lorsqu'il est un algorithme d'optimisation multi-objectif, utilise deux sous-fonctions (F) et (F'), la sous-fonction (F') relative à la K-couverture imposant qu'une position ($P_{m,n,q}$) dans ladite zone (Z) doive être couverte par au moins deux caméras ayant un recouvrement spatial (KC) entre leurs champs d'acquisition (CA) respectifs.

Selon une autre particularité, ladite sous-fonction (F') s'exprime par l'équation suivante:

$$F'_{mnq} = \left\{ \begin{pmatrix} i \\ j \\ k \\ \alpha \\ \beta \\ c \end{pmatrix}, P_{mnq}\ soit\ couvert\ au\ niveau\ r \geq 2 \right.$$

Selon une autre particularité, l'optimisation multi-objectif pour la K-couverture, ladite K-couverture étant un objectif, utilise l'équation:

$$Max\left\{\sum_{m=1}^{M}\sum_{n=1}^{N}\sum_{q=1}^{Q}W_{mnq}\cdot X_{mnq}\right\}$$

la variable $X_{mnq}$ étant définie par :

$$X_{mnq} = \begin{cases} 1, si\ le\ point\ P_{mnq} = (m,n,q)\ est\ K_{mnq} - couvert \\ 0\ sinon \end{cases}$$

Selon une autre particularité, lorsque l'algorithme est multi-objectif et la résolution (R) est une contrainte, le procédé utilise, pour ladite résolution (R), une équation de type:

$$\sum_{ijk\alpha\beta c\in F_{mnq}} Y_{ijk}^{c\alpha_t\beta_s} \geq Z_{mnq}, \forall\ m \in \{1,\dots,M\}, \forall\ n \in \{1,\dots,N,\}, \forall\ q \in \{1,\dots,Q\}$$

Selon une autre particularité, le procédé comprend une étape de prétraitement, basé sur l'ensemble de points issus de la discrétisation de la zone (Z) à surveiller, pour exclure les positions de caméras (1) ne pouvant pas couvrir un point, ($P_{m,n,q}$), à cause d'un obstacle dans la zone à surveiller.

Un autre but de la présente demande est de procédé un système palliant au moins certains inconvénients de l'art antérieur, notamment par la mise en œuvre dudit procédé tel que défini dans la présente demande.

Ce but est atteint par un système comprenant des moyens de traitement (20) et des moyens de mémorisation (21) pour la mise en œuvre du procédé selon la présente demande.

## DESCRIPTION DES FIGURES ILLUSTRATIVES

D'autres particularités et avantages de la présente invention apparaîtront plus clairement à la lecture de la description ci-après, faite en référence aux dessins annexés, dans lesquels :

la figure 1 représente schématiquement une vue en perspective d'une zone (Z) à surveiller par des caméras (1) de positions ($P_{i,j,k}$), avec éventuellement chacune un angle $\alpha$ de balayage vertical et/ou un angle $\beta$ de balayage horizontal, définissant un champ d'acquisition (CA) pour chacune des caméras déployées sur ladite zone (Z), avec au moins une résolution (R) souhaitées dans l'un des champs d'acquisition (CA) d'au moins une caméra (1), selon divers modes de réalisation ;

la figure 2 représente schématiquement la discrétisation d'une zone (Z) à surveiller, vue en perspective, pour définir des positions discrètes ($P_{m,n,q}$) parmis lesquelles les caméras (1) pourront être déployées sur des positions optimisées ($P_{i,j,k}$)

la figure 3 représente schématiquement une vue de dessus d'une zone (Z) à surveiller par des caméras (1) de positions ($P_{i,j,k}$), avec éventuellement chacune un angle $\alpha$ de balayage vertical et/ou un angle $\beta$ de balayage horizontal, définissant un champ d'acquisition (CA) pour chacune des caméras déployées sur ladite zone (Z), avec au moins une résolution (R) souhaitées dans l'un des champs d'acquisition (CA) d'au moins une caméra (1),selon divers modes de réalisation

la figure 4 représente schématiquement une vue en perspective d'un système (2) de déploiement de caméras (1) pour la surveillance d'une zone (Z), selon divers modes de réalisation

la figure 5 représente schématiquement divers niveaux de résolution (ou densité de pixels) nécessaires pour la surveillance d'une zone (Z) par des caméras, en fonction des besoins de reconnaissance ou d'identification ou de surveillance de la zone (Z).

**DESCRIPTION DES MODES DE REALISATION PREFERES DE L'INVENTION**

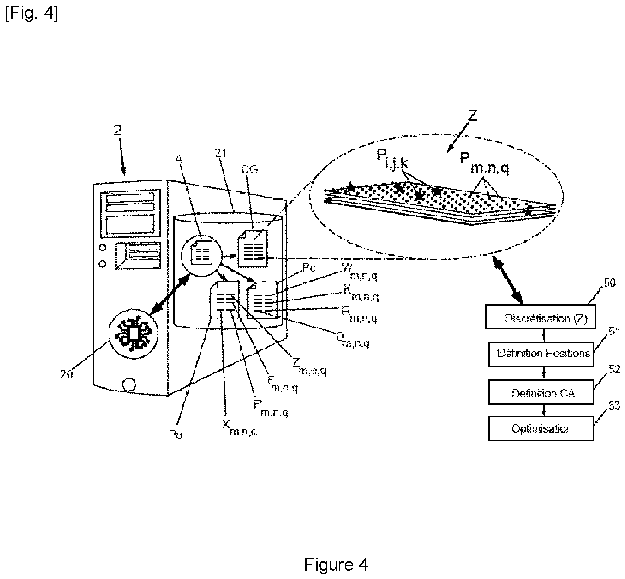

La présente demande concerne un procédé et/ou un système de déploiement de caméras (Voir figure 4), visant à améliorer la qualité de la surveillance, en tenant compte de multiples critères imposés par les personnes responsables de la surveillance d'une zone déterminée, mais également par des aspects d'ordres variés, tels que le coût et le type de caméras, ce qui induit des exigences quant à la qualité des images et des reconnaissances et/ou reconstructions faisables à partir de ces images.

Il est à noter que dans tous les travaux de la littérature, l'objectif principal est la couverture de l'espace surveillé. Dans la présente demande, l'approche originale proposée pour le déploiement des caméras est capable de tenir également compte des objectifs de traitement de données dans la phase d'exploitation. Le déploiement doit permettre de garantir des résolutions différentes en fonction des zones surveillées : des zones avec faible résolution pour une simple surveillance aux zones avec haute résolution pour une reconnaissance faciale. Le déploiement doit aussi permettre de garantir une couverture avec au moins 3 caméras dans certaines zones afin de garantir la fiabilité en cas de panne et aussi de garantir la possibilité de reconstruction 3D des objets filmés.

On notera que le paramètre de K-couverture (représentatif du recouvrement spatial entre les champs d'acquisition (CA) des caméras (1) pour chacun desdits points ($P_{mnq}$) de ladite zone), lorsqu'il est utilisé en tant que contrainte, la valeur seuil de ce paramètre peut être définie en fonction du but visé par cette contrainte. En effet, le recouvrement entre les champs (CA) offre de nombreux avantages tels que de permettre des reconstructions 3D, des suivis de cibles, des calculs de vitesse, mais il permet aussi que chacune des caméras (1) dont les champs se recouvrent puissent surveiller leur bon fonctionnement mutuel. On comprend que lorsque le but est de permettre une reconstruction 3D, le seuil sera souvent différent de celui nécessité pour garantir la fiabilité de l'ensemble de caméras (1) déployées. Ainsi, lorsque la K-couverture sert de contrainte, il est possible de préciser le degré de contrainte, par exemple à l'aide d'un paramètre à préciser par l'utilisateur pour préciser si le seuil implique le besoin d'une reconstruction tridimensionnelle (3D) des scènes capturées dans les vidéos enregistrées par lesdites caméras (1) ou simplement une garantie de fiabilité. Cette notion rejoint d'ailleurs les questions de vulnérabilité mentionnées dans la présente demande.

Le coût du déploiement est aussi reformulé pour intégrer, en plus du nombre de caméras, le coût d'installation de la caméra à chaque position 3D de l'espace et la vulnérabilité du lieu d'installation.

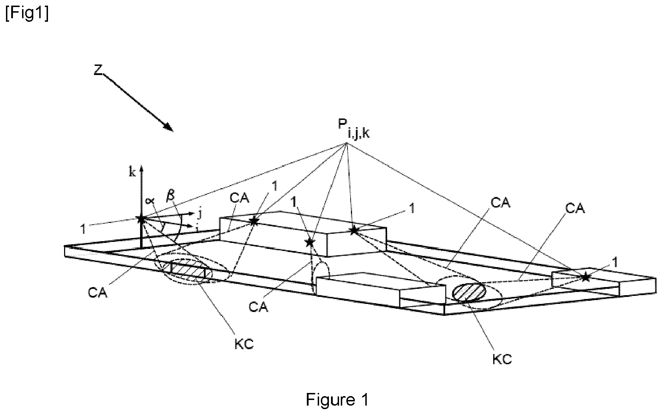

La première étape consiste à discrétiser l'espace 3D de déploiement (valeurs entières des coordonnées 3D des positions des caméras). Cette discrétisation concerne aussi bien les positions possibles des caméras que les points à couvrir. La figure 1 montre un exemple d'une telle discrétisation de l'espace 3D.

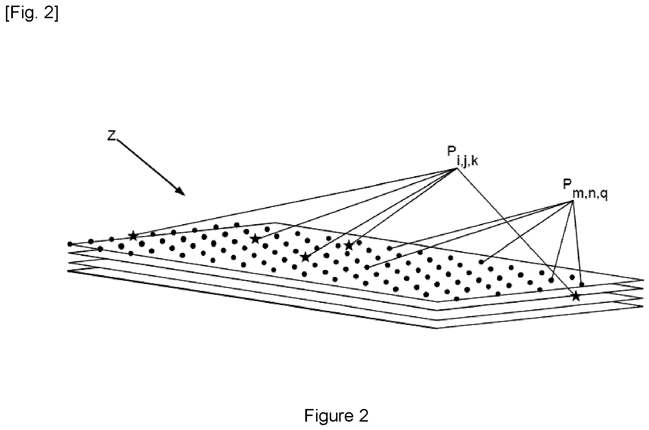

Donc, on suppose que la zone à surveiller est constituée de Z plans horizontaux superposés (voir figure 2). Chaque plan horizontal est numérisé en N x M points.

Dans certains modes de réalisation, la présente demande concerne un procédé de déploiement de caméras (1) de surveillance d'une zone (Z), pour l'optimisation l'efficacité de la surveillance, ledit déploiement étant réalisé sur la base d'une cartographie (CG) tridimensionnelle de ladite zone (Z), ladite cartographie (CG) incluant :

- une discrétisation (50) de ladite zone (Z) sous la forme d'un ensemble de points discrets ($P_{m,n,q}$) répartis dans un espace tridimensionnel représentatif de ladite zone (Z) à surveiller ;

- une définition (51) d'une position ($P_{i,j,k}$) pour chacune des caméras (1) à déployer dans ladite zone (Z), parmi ledit ensemble de points discrets ($P_{m,n,q}$);

- une définition (52) d'un champ d'acquisition (CA) pour chacune des caméras (1) à déployer dans ladite zone (Z);

ledit procédé étant caractérisé en ce qu'il comporte une optimisation (53) de paramètres, par au moins un algorithme (A) d'optimisation mono-objectif ou multi-objectifs:

- déterminant des valeurs optimales de paramètres multiples, ces paramètres comprenant une première catégorie de paramètres, dits objectifs (Po), dont les valeurs sont à optimiser par ledit algorithme d'optimisation et une seconde catégorie de paramètres, dits contraintes (Pc), dont les valeurs sont déterminées par un utilisateur lors de la mise en œuvre de l'algorithme d'optimisation;

- utilisant, soit en tant que paramètre de contrainte (Pc), soit en tant que paramètre d'objectif (Po), au moins les paramètres suivants:

  - au moins un paramètre ($R_{m,n,q}$), dit de résolution (R), représentatif de la résolution d'images souhaitée en certains points ($P_{m,n,q}$) de la zone (Z) à surveiller;

- au moins un paramètre ($D_{m,n,q}$), dit de coût d'installation de la caméra à la position ($P_{m,n,q}$), représentatif du nombre et/ou d'informations relatives à chacune des caméras (1) à déployer dans ladite zone, notamment en termes de caractéristiques techniques et/ou d'installation dans ladite zone (Z).

Dans certains modes de réalisation, le procédé comprend la définition d'un champ d'acquisition (CA) pour chacune des caméras (1) à déployer dans ladite zone (Z), ladite définition du dit champ d'acquisition (CA) étant fonction de la position ($P_{i,j,k}$) de chacune des caméras et d'une discrétisation des orientations des caméras, selon un angle de balayage (a) vertical, dit tilt, et un angle de balayage horizontal ($\beta$) vertical, dit pan.

Dans certains modes de réalisation, le procédé est caractérisé en ce qu'il comporte une définition d'un type (c) de caméra pour chacune des caméras (1) à déployer dans ladite zone (Z), ce type étant représentatif des caractéristiques techniques de la caméra en question.

Dans certains modes de réalisation, le procédé est caractérisé en ce que ledit algorithme utilise une sous-fonction (F) relative à la résolution (R) imposant qu'une position ($P_{m,n,q}$) dans ladite zone (Z) doive être couverte avec une résolution d'image ($R_{m,n,q}$).

Dans certains modes de réalisation, le procédé est caractérisé en ce que ladite sous-fonction (F) s'exprime par l'équation suivante :

$$F_{mnq} = \left\{ \begin{pmatrix} i \\ j \\ k \\ \alpha \\ \beta \\ c \end{pmatrix}, P_{mnq} \; soit \; couvert \; au \; niveau \; r = R_{mnq} \right.$$

dans laquelle $\alpha$ représente le tilt, $\beta$ représente le pan, c représente le type de caméra et r représente la résolution de la caméra souhaitée au point ($P_{m,n,q}$) couvert dans la zone (Z).

Dans certains modes de réalisation, le procédé est caractérisé en ce que ledit algorithme utilise un poids ($W_{m,n,q}$) permettant à un utilisateur dudit algorithme de définir une importance de la surveillance pour chacune des positions ($P_{m,n,q}$) au sein de ladite zone (Z). Dans certains modes de réalisation, l'ensemble des champs d'acquisition (CA) est défini pour couvrir au moins une partie dudit ensemble de points discrets ($P_{m,n,q}$), en fonction du poids attribué à chacun de ces points.

Dans certains modes de réalisation, le procédé est caractérisé en ce que, lorsque ledit paramètre ($R_{m,n,q}$) de résolution, lorsqu'il est utilisé en tant que paramètre de contraintes (Pc), ledit algorithme utilise une fonction Y pour l'ensemble caméras qui s'exprime selon l'équation suivante:

$$\sum_{ijk\alpha\beta c \in F_{mnq}} Y_{ijk}^{c\alpha_t\beta_s} \geq 1, \forall\, m \in \{1, \dots, M\}, \forall\, n \in \{1, \dots, N,\}, \forall\, q \in \{1, \dots, Q\}$$

Dans certains modes de réalisation, le procédé est caractérisé en ce que lorsque le coût est un objectif, le procédé utilise pour ledit coût une équation de type:

$$\sum_{c=1}^{C} \sum_{t=0}^{T} \sum_{s=0}^{S} \sum_{m=1}^{M} \sum_{n=1}^{N} \sum_{q=1}^{Q} \left(C_c + D_{mnq}\right) \cdot Y_{mnq}^{c\alpha_t\beta_s} \leq C_G$$

Dans certains modes de réalisation, le procédé est caractérisé en ce que lorsque le coût est un objectif, le procédé utilise pour ledit coût une équation de type:

$$Min \left\{ \sum_{c=1}^{C} \sum_{t=0}^{T} \sum_{s=0}^{S} \sum_{m=1}^{M} \sum_{n=1}^{N} \sum_{q=1}^{Q} \left(C_c + D_{mnq}\right) \cdot Y_{mnq}^{c\alpha_t\beta_s} \right\}$$

Dans certains modes de réalisation, le procédé est caractérisé en ce que lorsque la résolution (R) est un objectif, le procédé utilise pour ladite résolution une équation de type:

$$Max\left\{\sum_{m=1}^{M}\sum_{n=1}^{N}\sum_{q=1}^{Q}W_{mnq}\cdot Z_{mnq}\right\}$$

la variable $Z_{mnq}$ étant définie par

$$Z_{mnq} = \begin{cases} 1, si\ le\ point\ P_{mnq} = (m,n,q)\ est\ couvert\ avec\ une\ résolution\ R_{mnq} \\ 0\ sinon \end{cases}$$

Dans certains modes de réalisation, le procédé est caractérisé en ce que l'algorithme, lorsqu'il est un algorithme d'optimisation multi-objectif, utilise au moins un autre paramètre d'objectif (Po) à optimiser en même temps que le coût et/ou la résolution (R), l'un de ces derniers restant de préférence un paramètre (Pc) de contrainte.

Dans certains modes de réalisation, le procédé est caractérisé en ce que l'autre paramètre d'objectif (Po) à optimiser en même temps que le coût et/ou la résolution (R) est un paramètre dit de K-couverture représentatif du recouvrement spatial (KC) entre les champs d'acquisition (CA) des caméras (1) pour chacun desdits points ($P_{m,n,q}$) de ladite zone.

Dans certains modes de réalisation, le procédé est caractérisé en ce que l'algorithme, lorsqu'il est un algorithme d'optimisation multi-objectif, utilise deux sous-fonctions (F) et (F'), la sous-fonction (F') relative à la K-couverture imposant qu'une position ($P_{m,n,q}$) dans ladite zone (Z) doive être couverte par au moins deux caméras ayant un recouvrement spatial (KC) entre leurs champs d'acquisition (CA) respectifs.

Dans certains modes de réalisation, le procédé est caractérisé en ce que ladite sous-fonction (F') s'exprime par l'équation suivante:

$$F'_{mnq} = \left\{ \begin{pmatrix} i \\ j \\ k \\ \alpha \\ \beta \\ c \end{pmatrix}, P_{mnq}\ soit\ couvert\ au\ niveau\ r \geq 2 \right.$$

r=2 signifie que le point ($P_{m,n,q}$) est dans le champ de détection de la caméra.

Dans certains modes de réalisation, le procédé est caractérisé en ce que l'optimisation multi-objectif pour la K-couverture, ladite K-couverture étant un objectif, utilise l'équation :

$$Max\left\{\sum_{m=1}^{M}\sum_{n=1}^{N}\sum_{q=1}^{Q}W_{mnq}\cdot X_{mnq}\right\}$$

la variable $X_{mnq}$ étant définie par :

$$X_{mnq} = \begin{cases} 1, si\ le\ point\ P_{mnq} = (m,n,q)\ est\ K_{mnq} - couvert \\ 0\ sinon \end{cases}$$

Dans certains modes de réalisation, le procédé est caractérisé en ce que lorsque l'algorithme est multi-objectif et la résolution (R) est une contrainte, le procédé utilise, pour ladite résolution (R), une équation de type :

$$\sum_{ijk\alpha\beta c \in F_{mnq}} Y_{ijk}^{c\alpha_t\beta_s} \geq Z_{mnq}, \forall\, m \in \{1, \ldots, M\}, \forall\, n \in \{1, \ldots, N,\}, \forall\, q \in \{1, \ldots, Q\}$$

Dans certains modes de réalisation, le procédé est caractérisé en ce qu'il comprend une étape de prétraitement, basé sur l'ensemble de points issus de la discrétisation de la zone (Z) à surveiller, pour exclure les positions de caméras (1) ne pouvant pas couvrir un point, $(P_{m,n,q})$, à cause d'un obstacle dans la zone à surveiller.

L'homme de métier comprendra que les paramètres $(K_{mnq})$ et $(R_{mnq})$ respectivement relatifs à la K-couverture et le niveau de résolution (R) sont distincts des paramètres de décision $X_{mnq}$, $Y_{mnq}$, $Z_{mnq}$ définis dans la présente demande. En effet, les variables de décisions ne peuvent prendre que les valeurs 1 ou 0. Au contraire les paramètres $(K_{mnq})$ et $(R_{mnq})$ peuvent prendre des valeurs supérieures à 1. Par ailleurs, les paramètres $(K_{mnq})$ et $(R_{mnq})$ sont géographiquement hétérogènes. Ce qui implique qu'ils peuvent prendre différentes valeurs d'un point $(P_{mnq})$ à un autre en fonction de l'intérêt des zones à surveiller, de leur importance et des besoins en terme de post-traitement des images vidéo. Par exemple, et de manière non-limitative, le niveau de résolution exigée sera maximal pour des zones où on compte faire de la reconnaissance faciale, et pour des zones où on se limite à détecter une intrusion, le niveau de résolution peut être plus faible. Pour des zones où on souhaite faire de la reconstruction 3D et du tracking efficace, on peut exiger une 3-couverture (chaque point de l'espace est vu par au moins 3 caméras différentes). Pour des zones moins importantes, on peut se limiter à une 1-couverture (chaque point est couvert par au moins une caméra).

Ainsi, contrairement aux procédés de déploiement de l'art antérieur dans lesquels, en général, les caméras sont déployées sans prendre en compte l'hétérogénéité de la couverture des zones et/ou du niveau de résolution, le procédé de la présente demande permet de répondre aux problèmes de déploiement de caméras dans lesquels, par exemple et de manière non-limitative, l'utilisateur souhaiterait un déploiement avec pour objectif une K-couverture hétérogène en fonction de l'importance de la zone et avec pour contrainte un niveau de résolution (R) hétérogène pour l'ensemble des caméras. L'utilisateur pourrait également souhaiter avoir un déploiement avec pour objectif un niveau de résolution (R) hétérogène en fonction de l'importance de la zone et avec pour contrainte une K-couverture hétérogène pour l'ensemble des caméras en fonction de l'importance de la zone. L'utilisateur pourrait tout aussi souhaiter avoir pour objectifs une K-couverture hétérogène et un niveau de résolution (R) hétérogène pour les caméras à déployer. Il est bien entendu que dans les exemples de problèmes ci-dessus, le coût des caméras peut être pris en compte comme objectif ou contrainte.

L'invention concerne également un système de déploiement de caméras.

Dans certains modes de réalisation, le système comprenant des moyens de traitement (20) et des moyens de mémorisation (21) pour la mise en œuvre du procédé selon les revendications précédentes.

L'homme de métier comprendra donc aisément et sans ambiguïté à la lecture de la présente demande que cette dernière couvre également un système palliant au moins certains inconvénients de l'art antérieur, notamment par la mise en œuvre dudit procédé tel que défini dans la présente demande. En effet, un tel système comprendra des moyens de mémorisation (21) de données stockant les informations définies dans la présente demande, des moyens de sélections de paramètres (tels qu'une interface homme-machine connue de l'art antérieur) et des moyens de calculs/traitement (20) de données permettant la mise en œuvre du procédé selon divers modes de réalisation de l'invention.

Considérations Générales :

La présente demande détaille ci-dessous des considérations générales et des exemples de mises en œuvre de divers modes de réalisation, non limitatifs et qui ne sont pas forcément exclusifs les uns des autres (selon les détails fournis).

L'objectif de cette invention est d'optimiser le déploiement de caméras ayant des caractéristiques hétérogènes en respectant plusieurs contraintes liées à leurs caractéristiques intrinsèques, à la couverture de la zone surveillée, aux coûts d'installation, aux normes de sécurité et surtout à la précision des algorithmes d'analyse de données pouvant s'y rapporter.

Une recherche bibliographique préliminaire permet de cerner que les méthodes d'optimisation de déploiement consistent à minimiser le nombre de caméras en considérant principalement la contrainte de la couverture des zones de déploiement. Les variables à estimer sont les positions et les orientations 3D des caméras. Cependant, une étude approfondie de ces systèmes ainsi que des normes de sécurité auxquelles ils sont assujettis révèle la complexité de la chaîne d'acquisition et de traitement des données impliquant des coûts d'infrastructure non négligeables. Aussi, l'ensemble des paramètres à optimiser peut inclure les paramètres intrinsèques des caméras en plus de leurs positions et orientations 3D.

Donc, dans un premier temps, une modélisation des systèmes CCTV permet de définir un ensemble de paramètres mathématiques régissant la mise en place des caméras. Il s'agit de paramètres extrinsèques (placement et orientation 3D des caméras) et aussi de paramètres intrinsèques (focaux). Dans un deuxième temps, on propose un outil intégré d'aide à la décision tenant compte du déploiement et du traitement de données. Cet outil est basé sur une méthode d'optimisation dont l'objectif est de minimiser le coût d'installation tout en respectant les contraintes techniques et spatiales mentionnées ci-dessus.

Tenir compte de la précision et des besoins de traitement de données représente l'une des originalités de cette invention. Il s'agit de placer, orienter et régler les focaux des caméras afin de :

- Respecter des résolutions spatialement hétérogènes : Ces résolutions peuvent être prédéfinies par l'utilisateur en fonction de l'intérêt des différentes zones de la région surveillée. Par exemple, pour des zones où on compte faire de la reconnaissance faciale, la résolution exigée sera maximale et pour des zones où on se limite à détecter une intrusion, la résolution peut être plus faible.

- Respecter des contraintes de K-couverture spatialement hétérogènes : Pour des zones où on souhaite faire de la reconstruction 3D et du tracking efficace, on peut exiger une 3-couverture (chaque point de l'espace est vu par au moins 3 caméras différentes). Pour des zones moins importantes, on peut se limiter à une 1-couverture (chaque point est couvert par au moins une caméra).

Tenir compte des coûts de placement des caméras et de la vulnérabilité de leurs positions représente un autre aspect important de cette invention. Dans les systèmes classiques d'optimisation de déploiement, le coût d'installation est directement reliée au nombre des caméras. Cependant, en pratique, certaines positions de caméras coûtent plus ou moins chers en terme d'installation (par exemple, nécessité de faire des tranchées pour passer les câbles) et aussi sont plus ou moins vulnérables par rapport à des attaques extérieures ou à des conditions météorologiques (exposition au vent). Le procédé proposé dans cette invention permet la prise en compte de ces paramètres directement dans le modèle d'optimisation.

A l'ère du Big Data et dans un contexte de prolifération des caméras en tous genres, il est utile de se poser des questions quant au fonctionnement et au déploiement de ces composants technologiques en vue de traiter convenablement les informations qu'ils délivrent.

En effet, on parle aujourd'hui de façon récurrente de caméras intelligentes qui pré-analysent les données qu'ils recueillent afin de n'en transmettre que ce qui est pertinent pour une application précise. Ces organes sont ainsi dotés de :

- un senseur qui prend une mesure physique

- une source d'énergie qui alimente les différents sous-systèmes

- une unité de calcul (microprocesseur ou microcontrôleur) qui réalise les traitements préliminaires sur les données brutes

- une mémoire interne permettant une gestion autonome et une « bufferisation »

- un module de transmission

De par leurs caractéristiques intrinsèques, les caméras seraient hétérogènes dans la plupart des installations et ce indépendamment de la nature des mesures qu'ils prélèvent. Alors, il est nécessaire de penser en amont aux différents modes d'exploitation du système. De plus, malgré leur démocratisation, certaines de ces caméras n'ont pas forcément vu leurs coûts baisser. Donc, il est primordial de bien les placer pour en tirer le meilleur profit.

Ainsi, il s'avère judicieux de réfléchir plus généralement au déploiement de ces caméras en tenant compte des contraintes techniques et spatiales, le but étant d'avoir une performance accrue du système de caméras avec un coût maîtrisé.

Cette problématique peut être ramenée à un problème d'optimisation dont les contraintes sont principalement liées à la couverture, la précision du traitement, la vulnérabilité et les normes de sécurité.

Afin d'exprimer les exigences en termes de traitement des images, nous définissons les paramètres suivants qui vont être renseignés par l'utilisateur du logiciel :

- $\{W_{mnq}\}\_(m=1..M)$, n=1..N, q=1..Q) Chaque point ($P_{m,n,q}$) (ou position) de coordonnées (m, n, q) de la zone de surveillance est caractérisé par un poids (caractéristique de son importance) noté $W_{mnq}$ qui peut varier entre $W_{min}$ et $W_{max}$. Les valeurs de ces poids peuvent par exemple découler d'une étude de vulnérabilité du site surveillé. Les zones les plus vulnérables se voient alors attribuées les poids les plus élevés ;

- {K$_{mnq}$}_(m=1..M, n=1..N, q=1..Q) : C'est le nombre de caméras différentes qui doivent voir le point (P$_{m,n,q}$) de coordonnées (m, n, q). K$_{mnq}$ =1 signifie une couverture classique du point (P$_{m,n,q}$) alors que K$_{mnq}$=3 permet une reconstruction 3D d'un objet situé près du point (P$_{m,n,q}$). Un autre intérêt de couvrir avec plus qu'une caméra (redondance) est d'assurer la fiabilité de la surveillance de certaines zones.

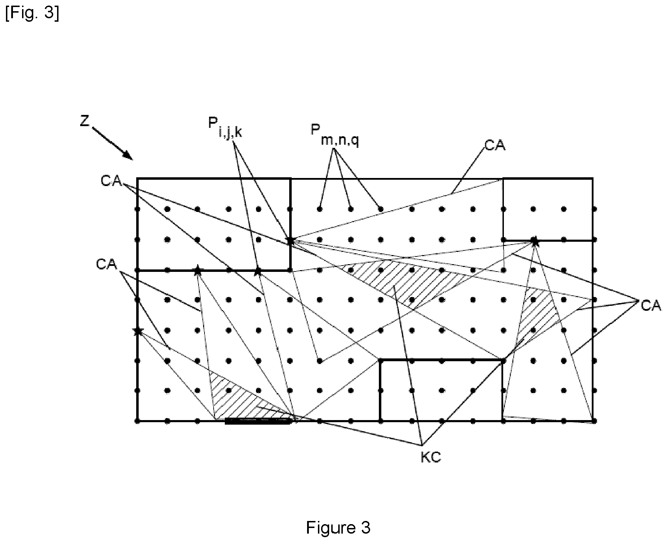

Si une caméra tombe en panne ou présente des problèmes de transmission, d'autres caméras sont en mesure d'assurer la fonction de surveillance. La figure 3 illustre une configuration où des zones sont couvertes par plus qu'une caméra pour assurer la fiabilité de la surveillance, la reconstruction 3D des objets avec plus qu'un champ de vue et la continuité d'un éventuel suivi (« tracking » en anglais) de cible.

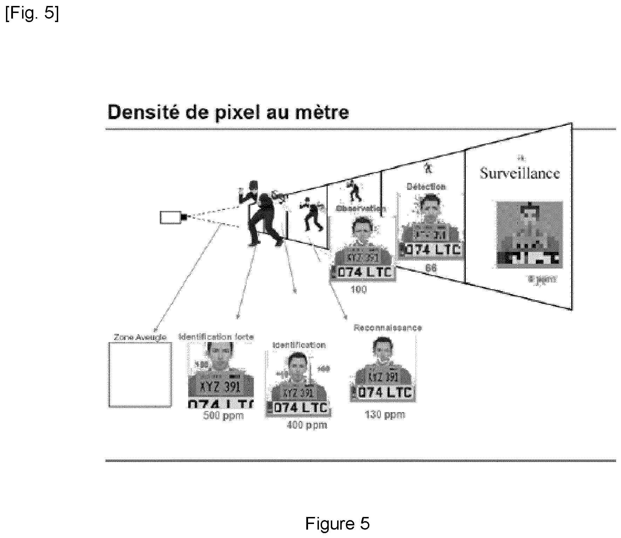

Dans certains modes de réalisation, la résolution des caméras est également prise en compte :
{R$_{mnq}$}_(m=1..M, n=1..N, q=1..Q) : C'est le niveau de résolution du point (P$_{m,n,q}$) vu par au point une caméra. En pratique, ce niveau de résolution (voir par exemple la figure 5) est quantifié sur 6 niveaux :

- R$_{mnq}$=1 signifie que le point (P$_{m,n,q}$) est dans le champ de surveillance de la caméra. Dans cette zone, on a une résolution d'à peu près 8 ppm (pixel/mètre) ;

- R$_{mnq}$=2 signifie que le point (P$_{m,n,q}$) est dans le champ de détection de la caméra. Dans cette zone, on a une résolution d'à peu près 66 ppm (pixel/mètre) ;

- R$_{mnq}$=3 signifie que le point (P$_{m,n,q}$) est dans le champ d'observation de la caméra. Dans cette zone, on a une résolution d'à peu près 100 ppm (pixel/mètre) ;

- R$_{mnq}$=4 signifie que le point (P$_{m,n,q}$) est dans le champ de reconnaissance de la caméra. Dans cette zone, on a une résolution d'à peu près 130 ppm (pixel/mètre) ;

- R$_{mnq}$=5 signifie que le point (P$_{m,n,q}$) est dans le champ d'identification de la caméra. Dans cette zone, on a une résolution d'à peu près 400 ppm (pixel/mètre) ;

- R$_{mnq}$=6 signifie que le point (P$_{m,n,q}$) est dans le champ d'identification forte de la caméra. Dans cette zone, on a une résolution d'à peu près 500 ppm (pixel/mètre) ;

Par exemple, pour réaliser une reconnaissance faciale au niveau d'une entrée, celle-ci doit être dans une zone avec des points d'indice R$_{mnq}$=5, soit 400 ppm.
Comme chaque point (i, j, k) représente une position possible de la caméra, on attribue aussi les poids suivants :
{D$_{mnq}$}_(m=1..M, n=1..N, q=1..Q) qui représentent le coût d'installation de la caméra au point (P$_{m,n,q}$). Par exemple, les endroits qui nécessitent de creuser des tranchées pour passer les câbles se voient attribués des poids élevés ;
De plus, dans certains modes de réalisation, il est possible de tenir compte de la vulnérabilité des caméras au sein de la dite zone. On utilise alors de préférence une formule du type :
{V$_{mnq}$}_(m=1..M, n=1..N, q=1..Q) qui représentent la vulnérabilité de placer la caméra au point (P$_{m,n,q}$). Par exemple, si une caméra placée au point (P$_{m,n,q}$) peut être très vulnérable aux actes de vandalisme, le poids V$_{mnq}$ doit être élevé.
En résumé, comme expliqué ci-dessus, le procédé et le système permettant sa mise en œuvre reposent sur un algorithme d'optimisation mono-objectif ou multi-objectif.
Dans le cas d'une optimisation mono-objectif, il est possible de formuler (par exemple et de manière non-limitative), la solution comme suit :
Une première approche du problème de déploiement consiste à déterminer le nombre, les positions (P$_{m,n,q}$) et les orientations $\alpha_t$ et $\beta_t$ des caméras, qui minimisent le coût de l'installation et sa vulnérabilité tout en respectant les contraintes de reconstruction 3D et les exigences de résolutions hétérogènes. En supposant qu'on dispose de C types de caméras, les variables de décision sont donc des variables binaires définies comme:

$$y_{mnq}^{c\alpha_t\beta_s} = \begin{cases} 1 \text{ si la caméra de type c est placée dans la position (m, n, q)} \\ \text{avec des angles } \alpha_t \text{ et } \beta_s \\ 0 \text{ sinon} \end{cases}$$

Les angles $\alpha_t$ et $\beta_t$ (tilt et pan) sont aussi discrétisés selon :

$$\alpha_t = \frac{t * \pi}{T} \; ; \; t \in \{0, 1, \dots T\}$$

$$\beta_s = \frac{s * 2.\pi}{S} \; ; \; s \in \{0, 1, \dots S\}$$

La fonction objective à minimiser s'écrit alors :

$$\text{Min} \left\{ \sum_{c=1}^{C} \; \sum_{t=0}^{T} \sum_{s=0}^{S} \sum_{m=1}^{M} \sum_{n=1}^{N} \sum_{q=Q}^{Z} (C_c + D_{mnq} + V_{mnq}) \cdot y_{mnq}^{c\alpha_t\beta_s} \right\}$$

où $C_c$ représente le coût de la caméra de type c, $D_{mnq}$ le coût d'installation de la caméra au point $(P_{m,n,q})$ et $V_{mnq}$ la vulnérabilité d'installer la caméra à la position $(P_{m,n,q})$.

**Contraintes:**

Afin de faciliter l'expression mathématique des contraintes de traitement, nous introduisons l'ensemble $F_{mnq}$ des positions et types de caméras qui couvre le point $(P_{m,n,q})$ selon sa contrainte de résolution $R_{mnq}$ et l'ensemble $F'_{mnq}$ des positions des caméras qui couvrent le point $(P_{m,n,q})$ sans exigence de résolution:

$$F_{mnq} = \left\{ \begin{pmatrix} i \\ j \\ k \\ \alpha \\ \beta \\ c \end{pmatrix}, P_{mnq} \; soit \; couvert \; au \; niveau \; r = R_{mnq} \right.$$

$$F'_{mnq} = \left\{ \begin{pmatrix} i \\ j \\ k \\ \alpha \\ \beta \\ c \end{pmatrix}, P_{mnq} \; soit \; couvert \; au \; niveau \; r \geq 2 \right.$$

L'avantage des ensembles $F_{mnq}$ et $F'_{mnq}$ est le fait qu'ils peuvent être calculés a priori avant la résolution du problème d'optimisation.

Contrainte de non-négativité :

$$y_{mnq}^{c\alpha_t\beta_s} \in \{0,1\} \; et \; \sum_c y_{mnq}^{c\alpha_t\beta_s} \leq 1$$

La valeur $y_{mnq}^{c\alpha_t\beta_s}=1$ signifie qu'on installe une caméra de type c au point $(P_{m,n,q})$ avec une orientation $\alpha_t$ et $\beta_t$. La deuxième contrainte signifie qu'à la même position et orientation, il y a au plus une seule caméra.

**Contrainte de K-couverture hétérogène :**

$$\sum_{ijk\alpha\beta c\in F'_{mnq}} Y_{ijk}^{c\alpha_t\beta_s} \geq K_{mnq}, \forall\, m \in \{1,...,M\}, \forall\, n \in \{1,...,N,\}, \forall\, q \in \{1,...,Q\}$$

**Contrainte de niveau de résolution hétérogène :**

$$\sum_{ijk\alpha\beta c\in F_{mnq}} Y_{ijk}^{c\alpha_t\beta_s} \geq 1, \forall\, m \in \{1,...,M\}, \forall\, n \in \{1,...,N,\}, \forall\, q \in \{1,...,Q\}$$

**Contrainte d'auto-protection** :

$$\sum_{c=1}^{C}\sum_{t=0}^{T}\sum_{s=0}^{S} Y_{mnq}^{c\alpha_t\beta_s} \leq \sum_{m'n'q'\alpha\beta c\in F'_{mnq}} Y_{m'n'q'}^{c\alpha_t\beta_s}$$

$m'\# m \,\forall\, m \in \{1,...,M\}, n' \neq n \,\forall\, n \in \{1,...,N,\}, q' \neq q \,\forall\, q \in \{1,...,Q\}$

Cette contrainte signifie que si on place une caméra à la position $(P_{m,n,q})$, elle doit être vue par au moins une autre caméra.

**Prise en compte d'obstacles**

Un autre intérêt de l'introduction des ensembles $F_{mnq}$ et $F'_{mnq}$ est le fait qu'ils peuvent encoder intrinsèquement les obstacles dans la scène surveillée. Les positions de caméras qui ne peuvent pas couvrir le point $(P_{m,n,q})$ à cause d'un obstacle sont simplement écartées des ensembles $F_{mnq}$ et $F'_{mnq}$. En effet, $F_{mnq}$ et $F'_{mnq}$ représentent les ensembles de positions des caméras qui peuvent couvrir le point $(P_{m,n,q})$ avec ou sans contrainte de résolution. A partir d'une carte 2D ou 3D contenant des informations sur les obstacles, on peut parcourir les points $(P_{m,n,q})$ et enlever les positions dans les ensembles $F_{mnq}$ et $F'_{mnq}$ qui ne peuvent pas assurer la couverture du point $(P_{m,n,q})$ considéré.

D'autre part, dans certains modes de réalisation de la présente demande, il est prévu d'utiliser un algorithme d'optimisation multi-objectif (c'est-à-dire avec plusieurs paramètres d'objectifs à minimiser ou maximiser afin de permettre un déploiement optimisé. Dans ces modes de réalisation multi-objectifs, la formulation mathématique pourra s'exprimer décrit ci-dessous.

Dans la formulation précédente, les contraintes de K-couverture et de résolution doivent être satisfaites. Cependant, en pratique, l'utilisateur souhaite avoir la possibilité de relaxer ces contraintes pour respecter son budget même si ce dernier a été minimisé dans la formulation mono-objective précédente. On propose dans cette deuxième formulation de reconsidérer les contraintes de K-couverture et de résolution comme des objectifs dont le taux de réalisation doit être maximisé. On se trouve alors avec un problème à triple objectifs : minimiser le coût de l'installation, maximiser le taux des points respectant leurs K-couverture et maximiser le taux des points respectant les contraintes de résolution.

On part des mêmes hypothèses que dans le cas précédent où l'utilisateur renseigne ses besoins en termes de poids d'importance (paramètres $\{W_{mnq}\}$), degrés de K-couverture (paramètres $\{K_{mnq}\}$), niveaux de résolution (paramètres $\{R_{mnq}\}$). L'utilisateur renseigne aussi les coûts d'installation des caméras en fonction des positions (paramètres $\{D_{mnq}\}$) et les degrés de vulnérabilité des positions d'installation (paramètres $\{V_{mnq}\}$).

On définit alors les 3 objectifs:

**Objectif de coût :**

$$Min\left\{\sum_{c=1}^{C}\sum_{t=0}^{T}\sum_{s=0}^{S}\sum_{m=1}^{M}\sum_{n=1}^{N}\sum_{q=1}^{Q}(C_c + D_{mnq} + V_{mnq}) \cdot Y_{mnq}^{c\alpha_t\beta_s}\right\}$$

Objectif de K-couverture :

$$Max\left\{\sum_{m=1}^{M}\sum_{n=1}^{N}\sum_{q=1}^{Q}W_{mnq} \cdot X_{mnq}\right\}$$

Avec $X_{mnq} = \begin{cases}1, si\ le\ point\ P_{mnq} = (m,n,q)\ est\ K_{mnq} - couvert \\ 0\ sinon\end{cases}$

Objectif de résolution :

$$Max\left\{\sum_{m=1}^{M}\sum_{n=1}^{N}\sum_{q=1}^{Q}W_{mnq} \cdot Z_{mnq}\right\}$$

Avec $Z_{mnq} = \begin{cases}1, si\ le\ point\ P_{mnq} = (m,n,q)\ est\ couvert\ avec\ une\ resolution\ R_{mnq} \\ 0\ sinon\end{cases}$

Dans ce problème multi-objectifs, les contraintes permettent d'établir les relations entre les variables binaires $y_{mnq}^{c\alpha_t\beta_s}$ et les variables $X_{mnq}$ et $Z_{mnq}$ qui ont été introduites afin de simplifier la formulation du problème.

**Contrainte 1 (pour les variables $X_{mnq}$):**

$$\sum_{ijk\alpha\beta c\in F'_{mnq}} Y^{c\alpha_t \beta_s}_{ijk} \geq K_{mnq}\cdot X_{mnq}, \forall\, m \in \{1,...,M\}, \forall\, n \in \{1,...,N,\}, \forall\, q \in \{1,...,Q\}$$

**Contrainte 2 (pour les variables $Z_{mnq}$):**

$$\sum_{ijk\alpha\beta c\in F_{mnq}} Y^{c\alpha_t \beta_s}_{ijk} \geq Z_{mnq}, \forall\, m \in \{1,...,M\}, \forall\, n \in \{1,...,N,\}, \forall\, q \in \{1,...,Q\}$$

Les contraintes de non-négativité, d'auto-protection et de prise en compte d'obstacles demeurent les mêmes que dans le cas mono-objectif.

Avec la formulation multi(3)-objectifs, l'utilisateur aura le choix de privilégier l'un ou l'autre des 3 objectifs. Par exemple, il peut fixer un maximum de budget à dépenser pour son installation et accepter de ne pas totalement satisfaire les contraintes de K-couverture et de résolution. Ceci pourrait-être simplement envisagé avec la gestion des solutions dominantes sur le front de Pareto associé au problème multi-objectifs.

Plusieurs approches de résolution peuvent être utilisées. A titre d'exemple, on peut considérer les méthodes suivantes : la méthode de la somme pondérée, la méthode de deux-phases ou la méthode $\varepsilon$- contrainte. Ces méthodes utilisent différentes démarches de détermination de la solution. La méthode de la somme pondérée consiste à combiner les objectifs du problème en une seule fonction objective pondérée, ajouter de nouvelles contraintes au modèle, puis résoudre itérativement le nouveau modèle mathématique obtenu. A chaque itération réalisée, on obtient une solution non dominée. Le principe de la méthode de deux phases consiste, dans une première phase, à trouver les solutions non supportées du front de Pareto, puis dans la deuxième phase, déterminer les solutions non supportées qui existent parmi les solutions déjà déterminées dans la première phase. Enfin, la méthode $\varepsilon$-contrainte, dans le cas bi-objectif, consiste à borner l'un des objectifs et à optimiser l'autre objectif en tenant compte de cette borne.

La présente demande décrit diverses caractéristiques techniques et avantages en référence aux figures et/ou à divers modes de réalisation. L'homme de métier comprendra que les caractéristiques techniques d'un mode de réalisation donné peuvent en fait être combinées avec des caractéristiques d'un autre mode de réalisation à moins que l'inverse ne soit explicitement mentionné ou qu'il ne soit évident que ces caractéristiques sont incompatibles ou que la combinaison ne fournisse pas une solution à au moins un des problèmes techniques mentionnés dans la présente demande. De plus, les caractéristiques techniques décrites dans un mode de réalisation donné peuvent être isolées des autres caractéristiques de ce mode à moins que l'inverse ne soit explicitement mentionné.

Il doit être évident pour les personnes versées dans l'art que la présente invention permet des modes de réalisation sous de nombreuses autres formes spécifiques sans l'éloigner du domaine d'application de l'invention comme revendiqué. Par conséquent, les présents modes de réalisation doivent être considérés à titre d'illustration, mais peuvent être modifiés dans le domaine défini par la protection demandée, et l'invention ne doit pas être limitée aux détails donnés ci-dessus.

**Revendications**

1. [Procédé de déploiement de caméras (1) de surveillance d'une zone (Z), pour l'optimisation l'efficacité de la surveillance, ledit déploiement étant réalisé sur la base d'une cartographie (CG) tridimensionnelle de ladite zone (Z), ladite cartographie (CG) incluant:

   - une discrétisation (50) de ladite zone (Z) sous la forme d'un ensemble de points discrets ($P_{m,n,q}$) répartis dans un espace tridimensionnel représentatif de ladite zone (Z) à surveiller ;
   - une définition (51) d'une position ($P_{i,j,k}$) pour chacune des caméras (1) à déployer dans ladite zone (Z), parmi ledit ensemble de points discrets ($P_{m,n,q}$);
   - une définition (52) d'un champ d'acquisition (CA) pour chacune des caméras (1) à déployer dans ladite zone (Z);

ledit procédé étant **caractérisé en ce qu'**il comporte une optimisation (53) de paramètres, par au moins un algorithme (A) d'optimisation mono-objectif ou multi-objectifs :

- déterminant des valeurs optimales de paramètres multiples, ces paramètres comprenant une première catégorie de paramètres, dits objectifs (Po), dont les valeurs sont à optimiser par ledit algorithme d'optimisation et une seconde catégorie de paramètres, dits contraintes (Pc), dont les valeurs sont déterminées par un utilisateur lors de la mise en œuvre de l'algorithme d'optimisation ;
- utilisant, soit en tant que paramètre de contrainte (Pc), soit en tant que paramètre d'objectif (Po), au moins les paramètres suivants :

• au moins un paramètre ($R_{m,n,q}$), dit de résolution (R), représentatif de la résolution d'images souhaitée en certains points ($P_{m,n,q}$) de la zone (Z) à surveiller ;
• au moins un paramètre ($D_{m,n,q}$), dit de coût d'installation de la caméra à la position ($P_{m,n,q}$), représentatif du nombre et/ou d'informations relatives à chacune des caméras (1) à déployer dans ladite zone, notamment en termes de caractéristiques techniques et/ou d'installation dans ladite zone (Z).

2. Procédé de déploiement de caméras (1) selon la revendication 1, **caractérisé en ce qu'**il comprend la définition d'un champ d'acquisition (CA) pour chacune des caméras (1) à déployer dans ladite zone (Z), ladite définition du dit champ d'acquisition (CA) étant fonction de la position ($P_{i,j,k}$) de chacune des caméras et d'une discrétisation des orientations des caméras, selon un angle de balayage (a) vertical, dit tilt, et un angle de balayage horizontal ($\beta$) vertical, dit pan.

3. Procédé de déploiement de caméras (1) selon l'une des revendications 1 et 2, **caractérisé en ce qu'**il comporte une définition d'un type (c) de caméra pour chacune des caméras (1) à déployer dans ladite zone (Z), ce type étant représentatif des caractéristiques techniques de la caméra en question.

4. Procédé de déploiement de caméras (1) selon l'une des revendications 1 à 3, **caractérisé en ce que** ledit algorithme utilise une sous-fonction (F) relative à la résolution (R) imposant qu'une position ($P_{m,n,q}$) dans ladite zone (Z) doive être couverte avec une résolution d'image ($R_{m,n,q}$).

5. Procédé de déploiement de caméras (1) selon les revendications 1 à 4, **caractérisé en ce que** ladite sous-fonction (F) s'exprime par l'équation suivante:

$$F_{mnq} = \left\{ \begin{pmatrix} i \\ j \\ k \\ \alpha \\ \beta \\ c \end{pmatrix}, P_{mnq} \; soit \; couvert \; au \; niveau \; r = R_{mnq} \right.$$

dans laquelle $\alpha$ représente le tilt, $\beta$ représente le pan, c représente le type de caméra et r représente la résolution de la caméra souhaitée au point ($P_{m,n,q}$) couvert dans la zone (Z).

6. Procédé de déploiement de caméras (1) selon la revendication 5, **caractérisé en ce que**, lorsque ledit paramètre ($R_{m,n,q}$) de résolution est utilisé en tant que paramètre de contraintes (Pc), ledit algorithme utilise une fonction Y pour l'ensemble caméras qui s'exprime selon l'équation suivante :

$$\sum_{ijk\alpha\beta c \in F_{mnq}} Y_{ijk}^{c\alpha_t\beta_s} \geq 1, \forall \, m \in \{1, ..., M\}, \forall \, n \in \{1, ..., N,\}, \forall \, q \in \{1, ..., Q\}$$

7. Procédé de déploiement de caméras (1) selon la revendication 1, **caractérisé en ce que** lorsque le coût est une contrainte, le procédé utilise une équation de type:

$$\sum_{c=1}^{C}\sum_{t=0}^{T}\sum_{s=0}^{S}\sum_{m=1}^{M}\sum_{n=1}^{N}\sum_{q=1}^{Q}(C_c + D_{mnq})\cdot Y_{mnq}^{c\alpha_t\beta_s} \leq C_G$$

et, lorsque le coût est un objectif, ledit procédé utilise pour ledit coût une équation de type :

$$Min\left\{\sum_{c=1}^{C}\sum_{t=0}^{T}\sum_{s=0}^{S}\sum_{m=1}^{M}\sum_{n=1}^{N}\sum_{q=1}^{Q}(C_c + D_{mnq})\cdot Y_{mnq}^{c\alpha_t\beta_s}\right\}$$

**8.** Procédé de déploiement de caméras (1) selon la revendication 1, **caractérisé en ce que** lorsque la résolution (R) est un objectif, le procédé utilise pour ladite résolution une équation de type :

$$Max\left\{\sum_{m=1}^{M}\sum_{n=1}^{N}\sum_{q=1}^{Q}W_{mnq}\cdot Z_{mnq}\right\}$$

la variable $Z_{mnq}$ étant définie par

$$Z_{mnq} = \begin{cases} 1, si\ le\ point\ P_{mnq} = (m,n,q)\ est\ couvert\ avec\ une\ résolution\ R_{mnq} \\ 0\ sinon \end{cases}$$

La variable $W_{m,n,q}$ étant un poids utilisé dans l'algorithme d'optimisation et permettant à un utilisateur dudit algorithme de définir une importance de la surveillance pour chacune des positions ($P_{m,n,q}$) au sein de ladite zone (Z).

**9.** Procédé de déploiement de caméras (1) selon la revendication 1, **caractérisé en ce que** l'algorithme, lorsqu'il est un algorithme d'optimisation multi-objectif, utilise au moins un autre paramètre d'objectif (Po) à optimiser en même temps que le coût et/ou la résolution (R), l'un de ces derniers restant de préférence un paramètre (Pc) de contrainte.

**10.** Procédé de déploiement de caméras (1) selon la revendication 9, **caractérisé en ce que** l'autre paramètre d'objectif (Po) à optimiser en même temps que le coût et/ou la résolution (R) est un paramètre dit de K-couverture représentatif du recouvrement spatial (KC) entre les champs d'acquisition (CA) des caméras (1) pour chacun desdits points ($P_{m,n,q}$) de ladite zone.

**11.** Procédé de déploiement de caméras (1) selon les revendications 4, 9 et 10, **caractérisé en ce que** l'algorithme, lorsqu'il est un algorithme d'optimisation multi-objectif, utilise deux sous-fonctions (F) et (F'), la sous-fonction (F') relative à la K-couverture imposant qu'une position ($P_{m,n,q}$) dans ladite zone (Z) doive être couverte par au moins deux caméras ayant un recouvrement spatial (KC) entre leurs champs d'acquisition (CA) respectifs, ladite sous-fonction (F') s'exprimant par l'équation suivante :

$$F'_{mnq} = \left\{\begin{pmatrix} i \\ j \\ k \\ \alpha \\ \beta \\ c \end{pmatrix}, P_{mnq}\ soit\ couvert\ au\ niveau\ r \geq 2.\right.$$

**12.** Procédé de déploiement de caméras (1) selon la revendication 11, **caractérisé en ce que** l'optimisation multi-objectif pour la K-couverture, ladite K-couverture étant un objectif, utilise l'équation : :

$$Max\left\{\sum_{m=1}^{M}\sum_{n=1}^{N}\sum_{q=1}^{Q}W_{mnq}\cdot X_{mnq}\right\}$$

la variable $X_{mnq}$ étant définie par :

$$X_{mnq} = \begin{cases}1, si\ le\ point\ P_{mnq} = (m,n,q)\ est\ K_{mnq} - couvert \\ 0\ sinon\end{cases}$$

**13.** Procédé de déploiement de caméras (1) selon les revendications 9 à 12, **caractérisé en ce que** lorsque l'algorithme est multi-objectif et la résolution (R) est une contrainte, le procédé utilise, pour ladite résolution (R), une équation de type:

$$\sum_{ijk\alpha\beta c\in F_{mnq}}Y_{ijk}^{c\alpha_t\beta_s} \geq Z_{mnq}, \forall\ m\in\{1,\dots,M\}, \forall\ n\in\{1,\dots,N,\}, \forall\ q\in\{1,\dots,Q\}$$

**14.** Procédé de déploiement de caméras (1) selon la revendication 1, **caractérisé en ce qu'**il comprend une étape de prétraitement, basé sur l'ensemble de points issus de la discrétisation de la zone (Z) à surveiller, pour exclure les positions de caméras (1) ne pouvant pas couvrir un point, ($P_{m,n,q}$), à cause d'un obstacle dans la zone à surveiller.

**15.** Système comprenant des moyens de traitement (20) et des moyens de mémorisation (21) pour la mise en œuvre du procédé selon les revendications précédentes.

[Fig1]

Figure 1

[Fig. 2]

Figure 2

[Fig. 3]

Figure 3

[Fig. 4]

Figure 4

[Fig. 5]

Figure 5

Europäisches
Patentamt

European
Patent Office

Office européen
des brevets

**RAPPORT DE RECHERCHE EUROPEENNE**

Numéro de la demande

EP 20 21 7983

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | JINWOO KIM ET AL: "Systematic Camera Placement Framework for Operation-Level Visual Monitoring on Construction Jobsites", JOURNAL OF CONSTRUCTION ENGINEERING AND MANAGEMENT, vol. 145, no. 4, 1 avril 2019 (2019-04-01) , page 04019019, XP055729873, US ISSN: 0733-9364, DOI: 10.1061/(ASCE)CO.1943-7862.0001636 | 1-10,14, 15 | INV. G06F30/20 H04N7/18 |
| Y | * abrégé * * page 4 - page 9 * * figures 1-4 * | 11-13 | |
| Y,D | REBAI MAHER ET AL: "Exact Biobjective Optimization Methods for Camera Coverage Problem in Three-Dimensional Areas", IEEE SENSORS JOURNAL, IEEE SERVICE CENTER, NEW YORK, NY, US, vol. 16, no. 9, 1 mai 2016 (2016-05-01), pages 3323-3331, XP011603385, ISSN: 1530-437X, DOI: 10.1109/JSEN.2016.2519451 [extrait le 2016-03-16] * page 3323 - page 3325 * | 11-13 | DOMAINES TECHNIQUES RECHERCHES (IPC) G06F H04N |
| A | US 2014/055621 A1 (SHIRANI SHAHRAM [CA] ET AL) 27 février 2014 (2014-02-27) * abrégé * | 1-15 | |

-/--

Le présent rapport a été établi pour toutes les revendications

| Lieu de la recherche | Date d'achèvement de la recherche | Examinateur |
|---|---|---|
| La Haye | 3 février 2021 | Lefol, Damien |

EPO FORM 1503 03.82 (P04C02)

Europäisches
Patentamt

European
Patent Office

Office européen
des brevets

**RAPPORT DE RECHERCHE EUROPEENNE**

Numéro de la demande

EP 20 21 7983

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | ROBERT BODOR ET AL: "Optimal Camera Placement for Automated Surveillance Tasks", JOURNAL OF INTELLIGENT AND ROBOTIC SYSTEMS ; THEORY AND APPLICATIONS - (INCORPORATING MECHATRONIC SYSTEMS ENGINEERING), KLUWER ACADEMIC PUBLISHERS, DO, vol. 50, no. 3, 3 octobre 2007 (2007-10-03), pages 257-295, XP019552834, ISSN: 1573-0409, DOI: 10.1007/S10846-007-9164-7 * abrégé *<br><br>----- | 1-15 | |
| | | | DOMAINES TECHNIQUES RECHERCHES (IPC) |

Le présent rapport a été établi pour toutes les revendications

| Lieu de la recherche | Date d'achèvement de la recherche | Examinateur |
|---|---|---|
| La Haye | 3 février 2021 | Lefol, Damien |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

EP 3 846 068 A1

**ANNEXE AU RAPPORT DE RECHERCHE EUROPEENNE
RELATIF A LA DEMANDE DE BREVET EUROPEEN NO.**

EP 20 21 7983

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

03-02-2021

| Document brevet cité au rapport de recherche | Date de publication | Membre(s) de la famille de brevet(s) | Date de publication |
|---|---|---|---|
| US 2014055621 A1 | 27-02-2014 | JP 5992090 B2 | 14-09-2016 |
| | | JP 2015517247 A | 18-06-2015 |
| | | US 2014055621 A1 | 27-02-2014 |
| | | US 2017150036 A1 | 25-05-2017 |
| | | WO 2013149340 A1 | 10-10-2013 |

Pour tout renseignement concernant cette annexe : voir Journal Officiel de l'Office européen des brevets, No.12/82

26

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- On-Full View Coverage in Camera Sensor Networks. **WANG, Y. ; CAO, G.** Proceedings IEEE. INFOCOM, 2011, 1781-1789
- **HORSTER, E. ; LIENHART, R.** Approximating Optimal Visual Sensor Placement. *IEEE International Conférence on Multimedia and Expo,* Juillet 2006, 1257-1260
- **HOWARD, A. ; MATARIC, M.J. ; SUKHATME, G.S.** An incremental self deployment algorithm for mobile sensor networks. *Autonomous Robots,* 2002, vol. 13 (2), 113-126

- **ZHANG, H. ; XIA, L. ; TIAN, F. ; WANG, P. ; CUI, J. ; TANG, C. ; DENG, N. ; MA,N.** An optimized placement algorithm for collaborative information processing at a wireless camera network. *IEEE International Conférence on Multimedia and Expo (ICME13),* 2013, 1-6
- **YABUTA, K. ; KITAZAWA, H.** Optimum Camera Placement Considering Camera Spécification for Security Monitoring. *ISCAS'08. IEEE International Symposium on Circuits and Systems,* 2008, 2114-2117
- **REBAI, M. ; LE BERRE, M. ; HNAIEN, F. ; SNOUSSI, H.** Exact Biobjective Optimization Methods for Camera Coverage Problem in Three-Dimensional Areas. *IEEE Sensors Journal,* 01 Mai 2016, vol. 16 (9